Europäisches Patentamt

European Patent Office

Office européen des brevets

(11) Publication number: **0 148 577**
A1

# EUROPEAN PATENT APPLICATION

(21) Application number: 84307837.9

(22) Date of filing: 13.11.84

(51) Int. Cl.⁴: **H 02 H 9/04**

(30) Priority: 14.11.83 US 551176

(43) Date of publication of application: 17.07.85
Bulletin 85/29

(84) Designated Contracting States: DE FR GB

(71) Applicant: **GENERAL SEMICONDUCTOR INDUSTRIES
INC., 2001 W. 10th Place, Tempe Arizona 85281 (US)**

(72) Inventor: **Skanadore, William R., 1659 W. Village Way,
Tempe Arizona 85282 (US)**

(74) Representative: **Boon, Graham Anthony et al, Elkington
and Fife High Holborn House 52/54 High Holborn,
London, WC1V 6SH (GB)**

(54) Overvoltage protection device.

(57) A low capacitance, overvoltage protection circuit comprising a relatively large area semiconductor overvoltage suppressor chip coupled between first and second power supply voltage conductor (12, 3). A low capacitance PIN diode (13 A–N) has one of its electrodes connected to a like electrode of the overvoltage suppressor chip and the other of its electrodes connected to a high speed signal conductor (14 A–N). During normal operation, the diode is always reversed biased, resulting in very low capacitance loading on the high speed signal conductor. During a transient overvoltage, the PIN diode is forward biased by the overvoltage, and forces reverse junction breakdown of the suppressor chip to occur, thereby limiting the amplitude of the overvoltage.

0148577

OVERVOLTAGE PROTECTION DEVICE

The present invention relates to overvoltage suppressor devices for preventing damage to electronic circuitry caused by transient overvoltages such as those caused by electrostatic discharges and other noise sources  and more particularly to PN junction overvoltage suppressors, especially ones having low reverse junction breakdown voltages which are often used to provide protection for low voltage integrated circuits.

Many PN junction voltage suppressor chips have relatively large junction areas and large associated junction capacitances.  For example, most of the suppressor devices marketed under the trademark TRANSZORB have junction capacitances in excess of 1,000 picofarads at zero junction bias voltage. Although such high values of junction capacitance may be desirable in certain instances, for example, when the voltage suppressor chips are connected between two DC power supply conductors, when it is desired to provide overvoltage protection to a high speed signal line, such large capacitances unduly load the high speed signal line.  Furthermore, PN junction capacitance is highly nonlinear, especially near zero bias voltages, and therefore can distort AC signals unacceptably.  One approach to solving this problem has been to connect a low capacitance diode in series with a PN junction voltage suppressor device by connecting one electrode of that diode to the high speed signal line and the other electrode of the diode to a like electrode of the voltage suppressor device.  The low capacitance diode then "robs" a bit of the high speed signal to forward bias the diode, charging up the large capacitance of the voltage suppressor chip to reverse bias its junction.  During high speed signal operation the diode ordinarily is reverse biased, and the high speed signal line is loaded only by the equivalent capacitance of the low diode junction capacitance connected in series with the high capacitance of the voltage suppressor chip.

This approach works quite well in certain circumstances, especially for where high overvoltages in excess of ten volts can be tolerated. However, lower voltage PN junction suppressor chips of the kind that go into reverse junction breakdown at five volts or less usually are very "leaky" or "soft". Their high leakage currents can cause severe problems with the above-mentioned low capacitance diode circuit because of there is a halting of data transmission on the high speed signal line for a period of time, the relatively high leakage current of the voltage suppressor chip can completely discharge the large capacitance of the suppressor chip. Then, when transmission of data resumes, the initial pulses of the data will forward bias the low capacitance diode, thereby directly coupling the high junction capacitance (typically 1,000 picofarads or more) of the suppressor chip directly to the high speed signal line. If the width of the initial data pulse is not much greater than the RC time constant associated with recharging the suppressor chip capacitance, (where R in this case is the effective impedance of the data pulse generator), then the initial data pulse probably will be lost. This problem is made worse by the fact that the suppressor chip junction capacitance has its maximum value at its discharged (zero bias) voltage.

Accordingly, it is an object of the invention to provide an improved, low capacitance, overvoltage suppressor circuit suitable for protecting high speed

0148577

data lines from transient overvoltages.

It is another object of the invention to avoid the loss of data caused by direct coupling of a high speed data signal to the high junction capacitance of an overvoltage suppressor chip.

It is another object of the invention to provide overvoltage transient protection to a large number of high speed signal lines at a minimum cost.

According to one aspect of the present invention there is provided a low capacitance protection circuit (10) for protecting a high speed signal conductor 114A-N, 27-29, 32, 33 from transient overvoltages, said protection circuit comprising in combination:

an overvoltage suppressor (2, 30, 60) having a first electrode and a second electrode, said overvoltage suppressor having a first capacitance;

a first power supply voltage conductor (12, 3, 40, 36, 57) coupled to said first electrode of said overvoltage suppressor;

a diode (13A-N, 21-26, 38, 39) diode having an anode and a cathode, said diode having a second capacitance;

first means for coupling one of said anode and said cathode of said diode to said first electrode of said overvoltage suppressor;

a second power supply voltage conductor (3, 12, 41, 37, 65) coupled to said second electrode of said overvoltage suppressor; and

second means for coupling said high speed signal conductor (14A-N, 27-29, 33, 32) to the other of said anode and cathode of said diode.

According to a further aspect of the invention there is provided a method of operating a circuit having first and second conductors conducting first and second power supply voltages and a third conductor conducting a high speed signal to protect said circuit from transient over/under voltages on said third conductor without causing unacceptable attenuation or distortion of said high speed signal during normal circuit operation, said method comprising the steps of:

applying said first power supply voltage (+V) of said first conductor (12, 40, 36) to a first electrode of an overvoltage suppressor (2).

applying said second power supply voltage (-V) on said second conductor (3, 41, 37) to a second electrode of said overvoltage suppressor (2), said overvoltage suppressor having a first capacitance between its first and second electrodes;

applying said high speed signal on said third conductor (14A-N, 27-29, 32, 33) to a first electrode of a diode (13A-N 21-26, 34, 35, 38, 39) said diode also having a second electrode, said diode having a second capacitance between its first and second electrodes, said second capacitance being much less than said first capacitance;

also applying said first voltage (+V) on said first conductor to said second electrode of said diode;

said first power supply voltage and said high speed signal being related such that during normal operation of said current said diode is reverse biased during the entire duration of said high speed signal; and

forward biasing said diode during a transient overvoltage or undervoltage to effect conducting that transient overvoltage to said first electrode of said overvoltage suppressor to cause said overvoltage suppressor to undergo an increased current flow mechanism and limit the magnitude of that transient overvoltage to a predetermined level.

Briefly described, one embodiment of the present invention provides a low capacitance overvoltage protection circuit and method for protecting at least one high speed signal line from a transient overvoltage or undervoltage without excessively loading (and thereby attenuating or distorting) high speed electrical signals. The low capacitance protection circuit includes a low voltage suppressor device having first and second electrodes coupled between first and second supply voltage conductors and a first diode having one of its electrodes connected to one electrode of the overvoltage suppressor device and having its other electrode coupled to a first high speed signal conductor. In the described embodiments of the invention, the overvoltage suppressor is a PN junction voltage suppressor chip having a large junction capacitance. The first diode is a PIN diode having a very low junction capacitance. The first and second supply voltage conductors maintain the voltage suppressor chip in a reverse bias condition, and one of the supply voltage conductors also maintains the PIN diode in a reverse bias condition during normal high speed signal operation. During the occurrence of a transient overvoltage on the high speed signal conductor, the PIN diode is forward biased, causing reverse breakdown of the PN junction of the overvoltage suppressor chip, thereby limiting the amplitude of the transient overvoltage.

In one embodiment of the invention, a plurality of PIN diodes each has its cathode connected to the cathode of the voltage suppressor chip, and each PIN diode has its anode connected to a separate respective high speed signal conductor. A plurality of other PIN diodes each has its anode connected to the anode of the voltage suppressor chip, and each has its cathode connected to a respective one of the high speed signal conductors.

In one embodiment of the invention, one of the high speed signal conductors is a centre conductor of a coaxial cable, and another of the high speed signal conductors is the electrically grounded shield of the high speed signal conductor.

Embodiments of the present invention will now be described by way of example with reference to the accompanying drawings, in which:

Fig. 1 is a schematic diagram of one embodiment of the present invention for providing protection against overvoltages;

Fig. 1A is a schematic diagram of another embodiment of the invention for providing protection against undervoltages;

Fig. 2A is a schematic circuit diagram of a prior art overvoltage suppressor circuit;

Fig. 2B is a schematic circuit diagram of another prior art low capacitance transient overvoltage and undervoltage protection circuit;

Fig. 3 is a circuit diagram of another low capacitance overvoltage protection circuit of the present invention;

Fig. 4 is a circuit diagram of yet another embodiment of the invention;

Fig. 5 is a plan view of practical implementation of the circuit shown in Fig. 3;

Fig. 6 is a partial section view of a PIN diode used in accordance with some embodiments of the present invention; and

Fig. 7 is a schematic diagram illustrating an application of an embodiment of the low capacitance overvoltage protection circuit of the present invention.

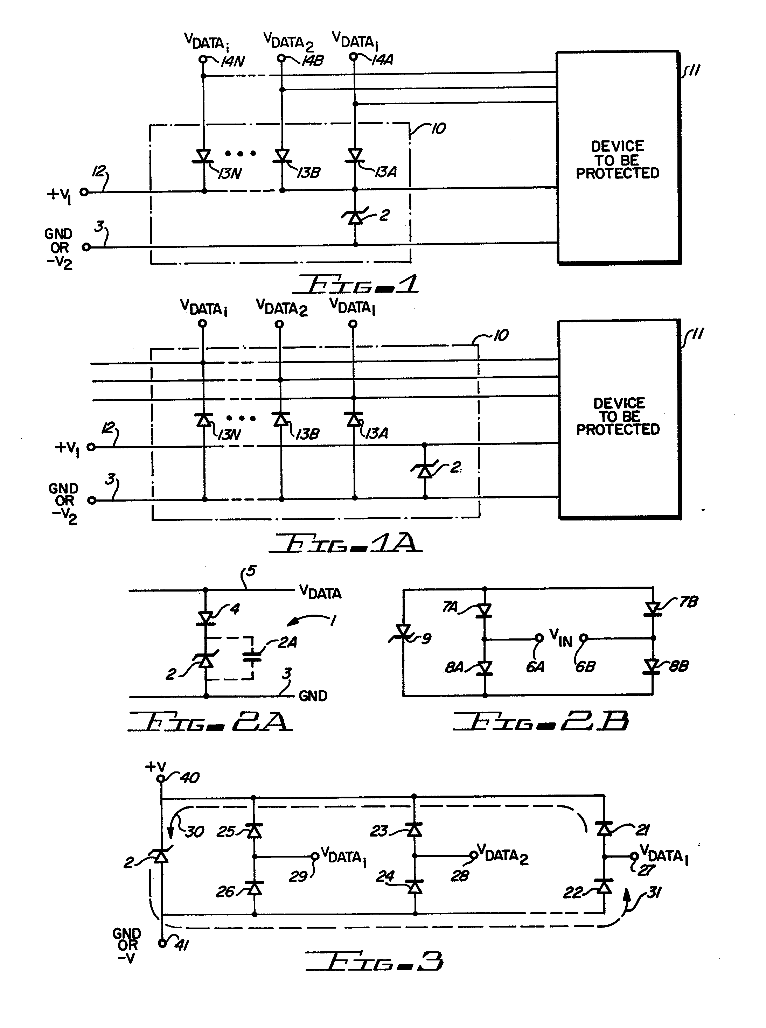

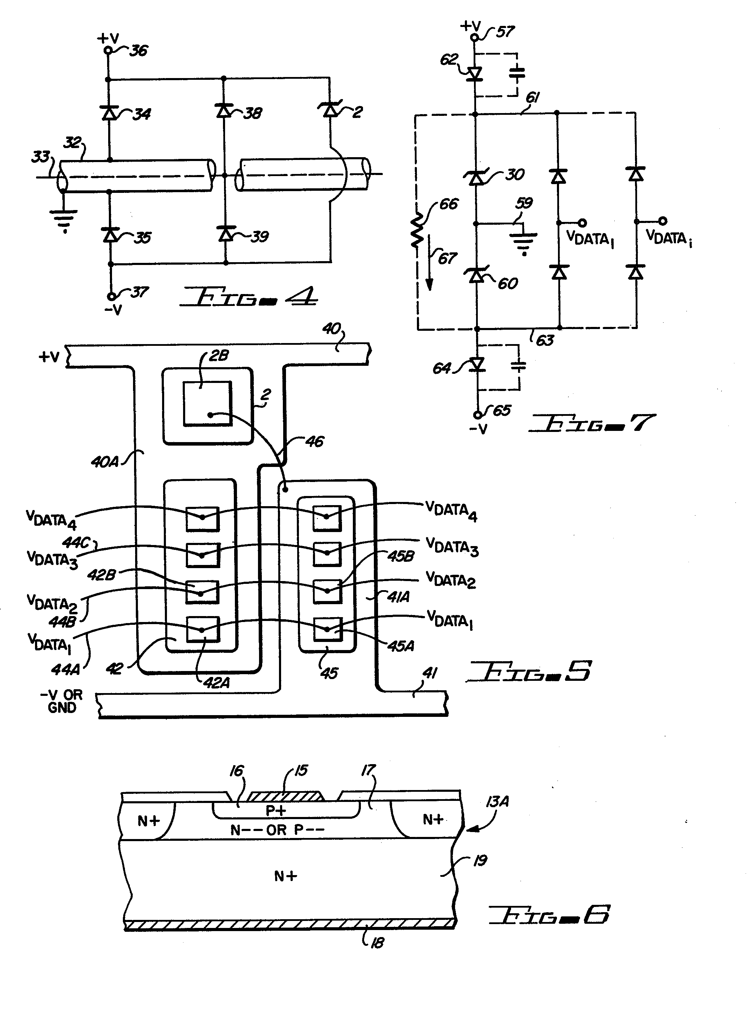

Referring first to Fig. 2A, a prior art transient

- 7 -

0148577

overvoltage protection circuit 1 includes a voltage protection diode 2, which can be a TRANSZORB protection device of the type previously mentioned. Its anode is connected to a ground conductor 3. Its cathode is connected to the cathode of a low capacitance PN diode 4. The anode of a low capacitance diode 4 is connected to a data conductor 5. Typically, the junction capacitance of voltage protection diode 2 might be in excess of 1000 picofarads, so obviously it ordinarily would not be desirable to connect data conductor 5 to the cathode of voltage protection diode 2 if the data signal is of high frequency, as attenuation and distortion of the data signal would otherwise occur. However, with diode 4 present, a positive transition of the signal on conductor 5 forward biases diode 4, thereby charging up the 1000 picofarad capacitance 2A of overvoltage protection diode 2. The next negative transition of the data signal on conductor 5 will reverse bias diode 4. The voltage on capacitor 2A holds overvoltage protection diode 2 in its reverse biased condition. The junction capacitance of diode 4 is normally very low, typically less than 25 picofarads. Consequently, the low equivalent series capacitance of suppressor diode 2 and diode 4 causes relatively little attenuation or distortion of the signal on high speed conductor 5.

However, if the signal on conductor 5 happens to be a high speed data signal having long pauses between data pulses, and voltage protection diode 2 happens to be one having a reverse breakdown voltage of as low as approximately five volts, there will be a significant reverse leakage current flowing across its PN junction. This leakage current will discharge capacitance 2A until protection diode 2 is approximately zero biased. This, unfortunately, is its maximum capacitance condition.

Then, the next positive-going pulse on data conductor 5 will forward bias diode 4, so that the signal on conductor 5 will have to charge the entire maximum (zero-bias) capacitance of capacitance 2A. If the charging time constant comprised of capacitance 2A and the output impedance of the data pulse generator is roughly the same as the width of the initial pulse of the resumed data transmission on conductor 5, then the data represented by the initial pulse probably will be lost, depending, of course, on the sensitivity of the receiving circuitry. Fig. 2B shows another prior art overvoltage and undervoltage protection circuit quite similar, at least in principle, to that of Fig. 2A. It is to be understood that the term "overvoltage" is used herein occasionally to refer to magnitudes of both overvoltages and undervoltages. For this circuit, a high frequency AC signal $V_{IN}$ is applied between conductors 6A and 6B. Two low capacitance diodes 7A, 7B, 8A and 8B protect conductor 6A and 6B from large negative transient overvoltages and undervoltages. The problem with this circuit is essentially the same as the problem with the circuit of Fig. 2A, namely that if there is a long pause in the transmission of the high speed signal $V_{IN}$, the high junction leakage current of voltage protection diode 9 will discharge its high junction capacitance, and when data transmission is resumed the initial portion of the resumed signal will be lost or substantially attenuated and/or distorted as the diodes 7A, 7B, 8A and 8B become variously forward biased and recharge the junction capacitance of voltage protection diode 9 from the initial portion of the resumed signal.

Referring now to Fig. 1, reference numeral 10 designates one embodiment of an improved voltage protection circuit in accordance with the present invention. In this circuit, reference numeral 2 again designates a voltage protection device. As before, reference numeral 3 designates a conductor which is at ground or at a suitable negative power supply voltage -V2. The anode of voltage protection diode 2 is connected to conductor 3, which is also connected to the ground input or suitable negative power supply voltage of a device to be protected, which is designated by reference numeral 11. Typically, the device 11 to be protected might be a CMOS integrated circuit, which cannot withstand a very high transient overvoltage without resulting in loss of data, or, even worse, physical destruction of the protected circuit 11.

The cathode of voltage protection diode 2 is connected to a positive power supply conductor 12 having a voltage +V1 applied thereto. Typically, V2 may be zero volts and V1 may be +3 to +15 volts for a CMOS integrated circuit. Positive power supply conductor lead 12 is also connected to the positive power supply input of protected device 11.

The plurality of PIN (P-intrinsic-N) diodes 13A, 13B... 13N each have their cathode connected to power supply voltage conductor 12. The anodes of each of diodes 13A, 13B.... 13N are respectively connected to high speed data signal input or output conductors 14A, 14B...14N, respectively, of protected device 11.

Even though the main purpose of the protection circuit 10 is to protect device 11 from positive transient overvoltages on high speed data conductors 14A, 14B...14N, protection circuit 10 has the further advantage of protecting device 11 from large positive transient overvoltages applied between power supply voltage conductors 3 and 12. It can readily be seen that if the reverse breakdown voltage of protection diode 2 is five volts, a transient overvoltage between conductors 12 and 3 of more than five volts will be effectively suppressed.

Next, to understand the operation of protection circuit 10 better, assume that V2 is zero volts and V1 is +5 volts. Also assume that each of the data signals $V_{DATA1}$, $V_{DATA\ 2}$, $V_{DATAi}$ are normally between one and five volts. Then, it can be seen that each of the diodes 13A, 13B...13N is reversed biased if the data input signal is less than five volts, and is zero biased if the data signal is equal to five volts. Therefore, the maximum capacitance added to each of the data input conductors 14A, 14B...14N is the zero bias junction capacitance of the respective diodes 13A, 13B...13N. It can be seen that any leakage current through voltage protection diode 2 is supplied by power supply voltage conductor 12, and the junction capacitance of protection diode 2 is never discharged. Thus, there is never any danger of loss of any portion of the signals $V_{DATA1}$, $V_{DATA2}$, etc. as a result of the above-described junction leakage-caused discharging of the junction capacitance of protection diode 2. Typically, PIN diodes 13A, 13B...13N might have a zero bias junction capacitance of less than 25 picofarads.

Fig. 6 shows a partial cross-sectional view of a typical PIN diode such as 13A, 13B, etc., wherein it can be seen that the anode 15 of PIN diode 13A is connected to a P+ region 16. P+ region 16 is diffused into a very lightly doped $N^{--}$ region or $P^{--}$ region 17. The resistivity of region 17 may be in the range from 100 to 1,000 hm centimeters. The cathode 18 is connected to the N+ substrate 19. Although PIN diodes have the lowest capacitance of

of any diodes that could be used to provide diodes 13A, 13B, etc.; it should be appreciated that it is not necessary that the diodes be PIN diodes. In fact, it is only necessary that they have a satisfactorily low junction capacitance and yet have the current carrying capability necessary to conduct the maximum expected current flowing in the conductors 14A, 14B, etc., respectively, during the maximum expected transient overvoltage condition. For example, gold doped switching diodes and relatively long base rectifier diodes may be suitable in certain circumstances.

Next, the operation of the circuit of Fig. 1 during such a positive transient overvoltage condition will be explained. Assume that a large transient overvoltage pulse occurs on conductor 14A. This will immediately forward bias diode 13A, causing a large surge current to flow into conductor 12. This will raise the voltage of conductor 12 to the point at which the reverse breakdown voltage of protection diode 2 will be exceeded. Assuming that the correct size of voltage protection device 2 has been utilized, the energy of the transient overvoltage pulse will be rapidly dissipated as the overvoltage current flows in the reverse direction through the PN junction of protection diode 2, limiting the magnitude of the overvoltage pulse on conductor 14A to the sum of the forward drop across diode 13A and the reverse breakdown voltage of voltage protection diode 2.

It readily can be seen that if diodes 13A-N are connected as shown in Fig. 1A, then circuit 11 will be protected from transient negative voltages or "undervoltages".

Referring now to Fig. 3, overvoltage protection diode 2 can be used in conjunction with a large number of low capacitance diodes to protect a large number of high speed data conductors against both positive overvoltages and negative undervoltages. For example, in Fig. 3, the cathodes of diodes 21, 23 and 25 are connected to the cathode of protection diode 2, which is connected to the positive power supply voltage +V. The anodes of diodes 22, 24 and 26 are connected to the anode of voltage protection diode 2, which is connected to a ground or -V power supply voltage conductor. A high speed data signal $V_{DATA1}$ conductor 27 is connected to the anode and cathode of diodes 21 and 22, respectively. The high speed signal $V_{DATA2}$ is coupled by means of conductor 28 to the anode of diode 23 and cathode of diode 24. Similarly, $V_{DATAi}$ is conducted by conductor 29 to the anode of diode 25 and cathode of diode 26.

It is assumed that each of the three signals $V_{DATA\ 1}$, $V_{DATA2}$, and $V_{DATAi}$, normally undergo transitions between the limits of +V and -V. Consequently, the diodes 21-26 are always reversed biased or zero biased, except during the occurrence of the a positive transient overvoltage or a negative transient undervoltage on one or more of conductors 27, 28 and 29.

The overvoltage protection circuit shown in Fig. 3 only adds the junction capacitance of two low capacitance diodes such as 21 and 22 to the data line of the input to or output from a protected circuit such as 11. For example, during normal operation, with $V_{DATA1}$ undergoing transitions within the range from -V volts to +V volts, the junction capacitance of diodes 21 and 22 adds in parallel to the other capacitances loading conductor 27. Both diodes 21 and 22 are reversed biased, so that the junction capacitance of diodes 21 and 22 is normally less than its maximum zero bias value.

Still referring to Fig. 3, during a positive transient overvoltage on conductor 27, diode 21 is forward biased, raising the voltage of the +V conductor enough to cause reverse breakdown of protection diode 2, which limits the overvoltage applied to conductor 27 by forcing current to flow in the reverse direction indicated by arrow 30. Similarly, if a negative transient undervoltage occurs on conductor 27, diode 22 is forward biased and a current is caused to flow in the reverse direction through junction protection diode 2 in the direction indicated by arrow 31, limiting the negative amplitude of that negative transient undervoltage pulse.

Referring nor to Fig. 4, a variation on the circuit shown in Fig. 3 is shown. Here, a coaxial cable has an outer shield 32 and an inner conductor 33. Outer conductor 32 is connected to the anode of diode 34 and to the cathode of diode 35. The cathode of diode 34 is connected to the cathode of protection diode 2. The anode of diode 35 is connected to the anode of protection diode 2. The cathode of protection diode 2 is also connected to a positive supply voltage conductor 36, and the anode of protection diode 2 is also connected to a negative or ground power supply voltage conductor 37. Inner conductor 33 is connected to the anode of diode 38, the cathode of which is connected to conductor 36. Inner conductor 33 is also connected to the cathode of diode 39, the anode of which is connected to conductor 37. In this circuit, the inner conductor 33 will typically undergo relatively large voltage transitions, so that capacitance of diodes 38 and 39 is important. These diodes should be low capacitance diodes, such as the PIN diodes described above.

Typically, however, the outer conductor 32 will be at ground voltage or some other suitable bias voltage. Its voltage level will vary only minutely, although a current signal corresponding to the high speed voltage signal on inner conductor 33 will flow in shield conductor 32. Since there are no significant voltage transitions on outer conductor 32, diodes 34 and 35 can be inexpensive, relatively high capacitance diodes.

The operation of the circuit shown in Fig. 4 to protect an integrated circuit to which the cable 32, 33 is connected is precisely as earler described with reference to the circuit of Fig. 3.

Referring now to Fig. 5, a practical implementation of the circuit shown in Fig. 3 is shown. The +V conductor 40 is attached to a relatively large metal pad 40A; both conductor 40 and pad 40A can be part of the lead frame of a DIP (dual in-line package). Reference numeral 2 designates a TRANSZORB voltage protection diode 2. Reference numeral 2B designates a metal bonding pad on voltage protection diode chip 2.

Reference numeral 42 designates a chip on which 4 PIN diodes such as 21, 23, and 25 of Fig. 3 are fabricated. Reference numerals 42A, 42B, etc., designate the bonding pads of these anodes of these PIN diodes. Reference numerals 44A, 44B, etc., designate the conductors on which the high speed signals $V_{data1}$, $V_{data2}$ etc., are applied. These conductors are connected to corresponding inputs or outputs of a device to be protected such as 11 in Fig. 1. Reference numeral 41 designates another portion of the lead frame of the dual in line package, having another pad 41A on which a second chip 45 containing a second group of diodes corresponding to 22, 24 and 26 of Fig. 3 are fabricated. Reference numerals 45A, 45B, etc., designate bonding pads of the cathodes of the latter diodes. Reference numeral 46 designates a wire bond or lead frame conductor from the anode 2B of protection diode 2 to negative conductor 41. Since chip 2 is die bonded or soldered to positive conductor 40, its cathode is directly bonded to conductor 40. Similarly, the cathode of chip 42 is bonded directly to metal pad 40A. The anode of chip 45 is bonded directly to the pad 41A.

It is understood that the chips 42 and 45 containing multiple diodes could be replaced by individual diodes. The example depicted is viewed as a potentially more cost effective means of implementation.

Fig. 7 shows an overvoltage and undervoltage protection circuit which may be exceptionally useful in a system with a positive power supply voltage +V on conductor 57, a negative voltage supply -V on conductor 65, and a ground voltage supply level on conductor 59. This circuit is similar to the circuit shown in Fig. 3 except that a second TRANSZORB PN junction protection device 60 is provided. The protection device 30 has its cathode connected to conductor 61 and its anode connected to ground conductor 59. Conductor 61 can be connected directly or by means of a forward biased diode 62 to +V conductor 57. Protection diode 60 has its anode connected to conductor 63 and its cathode connected to ground conductor 59. Conductor 63 can be connected directly or by means of a forward biased diode 64 to -V conductor 65.

The advantage of using forward biased diodes 62 and 64 is that they may, in some instances, prevent overvoltages and undervoltages on the signal lines $V_{DATA1}$, or $V_{DATAi}$, from forward biasing and destroying parasitic integrated circuit diodes coupled between

- 16 -                                    0148577

output terminals of MOS transistors and the initial power supply conductors, such as the Vss and Vdd conductors. The diodes 62 and 64, if used, are forward biased by the relatively high leakage currents of TRANSZORB devices 30 and 60. Reference numeral 66 represents the effective resistance of TRANSZORB devices 30 and 60 and 67 designates the reverse leakage current, which causes diodes 62 and 64 to have a fairly high diffusion capacitance which, in turn, helps prevent forward biasing of the above-mentioned parasitic diodes during transient overvoltages. This diffusion capacitance can be further enhanced by decreasing the value of resistance 66, either by providing protection diodes 30 and 60 with high leakage currents or adding external resistance in parallel with resistance 66.

While the invention has been described with reference to a number of particular embodiments thereof, those skilled in the art will be able to make similar devices without departing from the scope of the invention. It is intended that all devices, the elements of which perform substantially the same function in substantially the same way to obtain substantially the same results, be encompassed by the present invention. For example, the overvoltage suppressor can be other than a PN junction type.

CLAIMS:

1. A low capacitance protection circuit (10) for protecting a high speed signal conductor (14A-N, 27-29, 32, 33) from transient overvoltages, said protection circuit comprising in combination:

an overvoltage suppressor (2,30,60) having a first electrode and a second electrode, said overvoltage suppressor having a first capacitance;

a first power supply voltage conductor (12,3,40, 36, 57) coupled to said first electrode of said overvoltage suppressor;

a diode (13-A-N, 21-26, 38,39) having an anode and a cathode said diode having a second capacitance;

first means for coupling one of said anode and said cathode of said diode to said first electrode of said overvoltage suppressor;

a second power supply voltage conductor (3,12,41, 37,65) coupled to said second electrode of said overvoltage suppressor; and

second means for coupling said high speed signal conductor (14A-N, 27-29, 33,32) to the other of said anode and cathode of said diode.

2. A circuit of Claim 1 wherein said diode is a PIN diode.

3. A circuit of Claim 1 or 2 including a further diode (13A-N, 21-26, 34,35,38,39) having an anode and a cathode, one of said anode and said cathode of said further diode being coupled to said first electrode of said overvoltage suppressor (2), the other one of said anode and said cathode of said further diode being coupled to a further high speed signal conductor (14A-N, 27-29, 32,33).

4. A circuit of Claim 1 or 2 including a further diode (22,24,26,35,39) having an anode and a cathode, said cathode of the first mentioned diode (21,23,25, 34,38) being coupled to said first electrode of said overvoltage suppressor (2), said anode of said
further diode being coupled to said second electrode
of said overvoltage suppressor, said cathode of
said further diode being coupled to said high speed
signal conductor (27-29,32,33).

5.    A circuit of Claim 4 wherein said high speed
signal conductor is a centre conductor (33) of a
coaxial transmission line and said further high
speed signal conductor is the outer conductor (32)
of said coaxial transmission line.

6.    A circuit of any preceding Claim wherein said
overvoltage suppressor includes a PN junction
overvoltage suppressor (2), said first electrode and
said second electrode of said overvoltage suppressor
being its cathode and anode, respectively.

7.    A circuit of Claim 5 wherein the power supply
voltages on said and said further power supply
voltage conductors, respectively, maintain said PN
junction overvoltage suppressor (2) in a reverse
biased condition. .

8.    A method of operating a circuit having first
and second conductors conducting first and second
power supply voltages and a third conductor conducting
a high speed signal to protect said circuit from
transient over/under voltages on said third conductor
without causing unacceptable attenuation  or distortion
of said high speed signal during normal circuit
operation, said method comprising the steps of:

applying said first power supply voltage
(+V) on said first conductor (12,40,36) to a first
electrode of an overvoltage suppressor (2).

applying said second power supply voltage (-V)
on said second conductor (3,41,37) to a second
electrode of said overvoltage suppressor (2), said
overvoltage suppressor having a first capacitance

- 19 -

0148577

between its first and second electrodes;

applying said high speed signal on said third conductor (14-A-N, 27-29, 32,33) to a first electrode of a diode (13A-N, 21-26, 34,35,38,39) said diode also having a second electrode, said diode having a second capacitance between its first and second electrodes, said second capacitance being much less than said first capacitance;

also applying said first voltage (+V) on said first conductor to said second electrode of said diode;

said first power supply voltage and said high speed signal being related such that during normal operation of said current said diode is reverse biased during the entire duration of said high speed signal; and

forward biasing said diode during a transient overvoltage or undervoltage to effect conducting that transient overvoltage to said first electrode of said overvoltage suppressor to cause said overvoltage suppressor to undergo an increased current flow mechanism and limit the magnitude of that transient pvervoltage to a predetermined level.

9. A method pf Claim 8 wherein said circuit has a fourth conductor (14A-N, 27-29,32,33) conducting a further high speed signal, said method including applying said further high speed signal on said fourth conductor to a first electrode of a further diode (21,23,25,34,38) said further diode also having a second electrode, and applying said first voltage on said first conductor to said second electrode of said further diode.

10. A method according to Claim 8 further comprising applying said high speed signal on said third conductor (27-29,33) to the cathode of a further diode (22,24,26,39) the capacitance of which is much less than said first capacitance, . and applying said second power supply voltage (-V) on said second conductor (41,37) to the anode of said further diode, said second power supply voltage being less than said high speed signal during normal operation of said circuit so that said further diode remains reverse biased.

1/2                                    0148577

Fig-1

Fig-1A

Fig-2A

Fig-2B

Fig-3

_Fig-4_

_Fig-7_

_Fig-5_

_Fig-6_

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | GB-A-1 495 456 (DUCELLIER & CIE.) <br> * Page 1, lines 9-35; figure * | 1,8 | H 02 H 9/04 |
| Y | DE-B-2 409 901 (SIEMENS AG.) <br> * Claims 1,3.5; column 4, lines 50-61 * | 1,8 | |
| A | CH-A- 487 524 (ZELLWEGER AG.) <br> * Column 1, lines 30-34; claim 1 * | 2 | |
| A | US-A-4 390 919 (L.C. LESINSKI) <br> * Claim 1; figures 1,2 * | 5 | |
| A | DE-A-2 754 409 (N.V. PHILIPS) <br><br> * Figures 1,2 * | | **TECHNICAL FIELDS SEARCHED (Int. Cl.4)** <br><br> H 02 H 9/04 |

The present search report has been drawn up for all claims

| Place of search <br> BERLIN | Date of completion of the search <br> 08-02-1985 | Examiner <br> LEMMERICH J |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82